# EUROPEAN PATENT APPLICATION

(11) **EP 4 535 408 A2**
(43) Date of publication of application: **09.04.2025**
(21) Application number: 24200602.1
(22) Date of filing: 16.09.2024
(51) Int. Cl.: H01L 21/67

(54) **SUBSTRATE PROCESSING METHOD, METHOD OF MANUFACTURING SEMICONDUCTOR DEVICE, PROGRAM, AND SUBSTRATE PROCESSING APPARATUS**

(30) Priority: 03.10.2023 JP 2023172049
(71) Applicant: Kokusai Electric Corporation, Tokyo 101-0045 (JP)
(72) Inventor: NAKATANI, Kimihiko, Toyama-shi, Toyama, 939-2393 (JP); MIYATA, Shoma, Toyama-shi, Toyama, 939-2393 (JP); WASEDA, Takayuki, Toyama-shi, Toyama, 939-2393 (JP)
(74) Representative: Bardehle Pagenberg Partnerschaft mbB Patentanwälte Rechtsanwälte

(57) **Abstract**

There is provided a technique that includes: (a) regulating a temperature in a process chamber (201) configured to accommodate a plurality of substrates (200) so that a temperature distribution in an arrangement direction of the substrates (200) in the process chamber (201) becomes a first distribution in which at least a portion of an inside of the process chamber (201) becomes a first temperature; (b) loading the substrates (200) into the process chamber (201) in a state where the temperature distribution in the arrangement direction is the first distribution; (c) after (b), regulating the temperature in the process chamber (201) so that the temperature distribution in the arrangement direction becomes a second distribution in which at least a portion of the inside of the process chamber (201) becomes a second temperature different from the first temperature; and (d) after (c), processing the substrates (200) in a state where the temperature distribution in the arrangement direction is the second distribution.

## Description

### CROSS-REFERENCE TO RELATED APPLICATION

This application is based upon and claims the benefit of priority from Japanese P atent Application No. 2023-172049, filed on October 3, 2023, the entire contents of whi ch are incorporated herein by reference.

### TECHNICAL FIELD

The present disclosure relates to a substrate processing method, a method of man ufacturing a semiconductor device, a program, and a substrate processing apparatus.

### BACKGROUND

In the related art, as a process of manufacturing a semiconductor device, a proces s of loading a substrate into a process chamber may be performed.

By loading the substrate into the process chamber, a temperature distribution in t he process chamber may be changed to a temperature distribution different from a temp erature distribution (target temperature distribution) used when processing the substrat e. In this case, in order to converge the changed temperature distribution to the target t emperature distribution, a temperature in the process chamber may be regulated using a temperature regulating means such as a heater or the like. However, it may take time to converge the changed temperature distribution to the target temperature distribution

### SUMMARY

Some embodiments of the present disclosure provide a technique capable of shor tening a time required for converging a temperature distribution in a process chamber, which fluctuates when loading a substrate into the process chamber, to a target tempera ture distribution, thereby improving a throughput of substrate processing.

According to embodiments of the present disclosure, there is provided a techniqu e that includes: (a) regulating a temperature in a process chamber configured to accom modate a plurality of substrates so that a temperature distribution in an arrangement di rection of the substrates in the process chamber becomes a first distribution in which at least a portion of an inside of the process chamber becomes a first temperature; (b) load ing the substrates into the process chamber in a state in which the temperature distribut ion in the arrangement direction in the process chamber is the first distribution; (c) afte r (b), regulating the temperature in the process chamber so that the temperature distrib ution in the arrangement direction in the process chamber becomes a second distributio n in which at least a portion of the inside of the process chamber becomes a second tem perature different from the first temperature; and (d) after (c), processing the substrates in a state in which the temperature distribution in the arrangement direction in the proc ess chamber is the second distribution.

### BRIEF DESCRIPTION OF DRAWINGS

The accompanying drawings, which are incorporated in and constitute a part of t he specification, illustrate embodiments of the present disclosure.
FIG. 1 is a schematic diagram of a vertical process furnace of a substrate processi ng apparatus suitably used in embodiments of the present disclosure, in which a portion of the process furnace is illustrated in a vertical cross-sectional view.

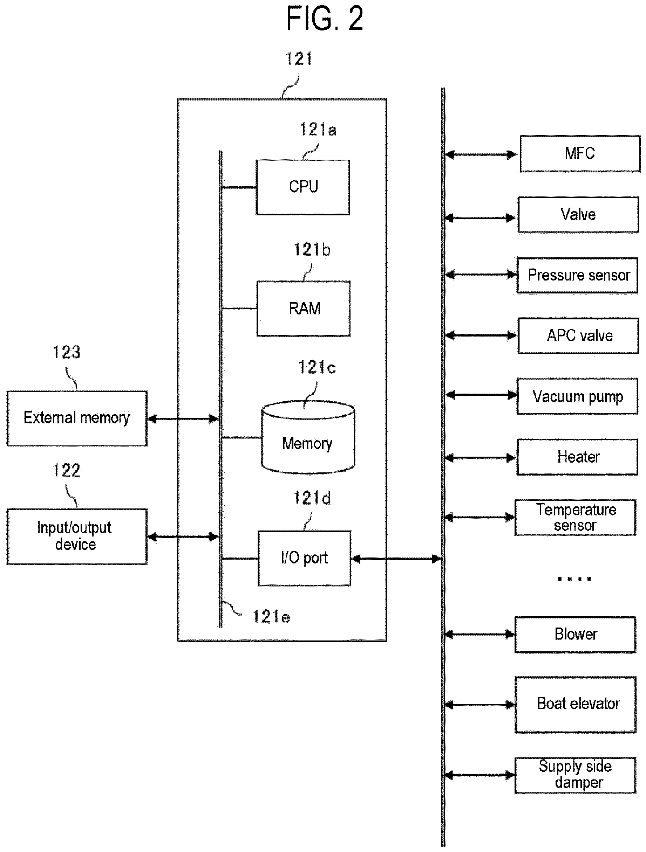

FIG. 2 is a schematic configuration diagram of a controller of the substrate proces sing apparatus suitably used in the embodiments of the present disclosure, in which a co ntrol system of the controller is illustrated in a block diagram.
FIG. 3 is a diagram showing temperature changes in upper, central, and lower reg ions of a process chamber in the embodiments of the present disclosure.
FIG. 4 is a diagram showing temperature changes in the upper, central, and lower regions of the process chamber in modification 1.
FIG. 5 is a diagram showing temperature changes in the upper, central, and lower regions of the process chamber in modification 2.

### DETAILED DESCRIPTION

Reference is now made in detail to various embodiments, examples of which are i llustrated in the accompanying drawings. In the following detailed description, numero us specific details are set forth in order to provide a thorough understanding of the prese nt disclosure. However, it will be apparent to one of ordinary skill in the art that the pre sent disclosure may be practiced without these specific details. In other instances, well-known methods, procedures, systems, and components are not described in detail so as not to obscure aspects of the various embodiments.

### <Embodiments of the Present Disclosure>

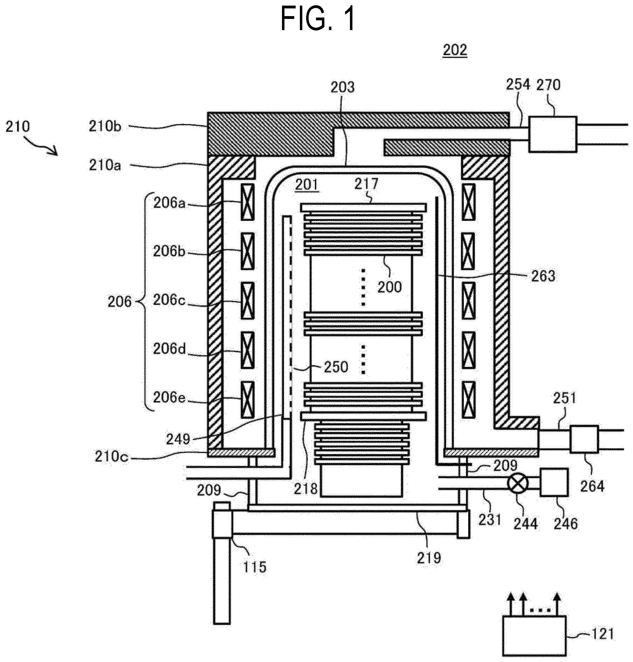

Embodiment of the present disclosure are described below mainly with reference to FIG. 1. All drawings used in the following description are schematic, and the dimensi onal relationships among respective elements, the proportions of respective elements, a nd the like shown in the drawings may not match the actual ones. Furthermore, the dim ensional relationships among respective elements, the proportions of respective element s, and the like may not match among a plurality of drawings.

### (1) Configuration of Substrate Processing Apparatus

As shown in FIG. 1, the process furnace 202 includes a heater 206 as a temperatu re regulator (heating part). The heater 206 is formed in a cylindrical shape with open u pper and lower ends, and is installed vertically. The heater 206 is composed of five zone heaters 206a, 206b, 206c, 206d and 206e arranged sequentially from the top along an a rrangement direction of wafers 200 as substrates. These heaters 206a to 206e are confi gured such that a temperature of each zone may be controlled individually and independ ently. The heater 206 also functions as an activator (exciter) that activates (excites) a ga s with heat. An outer wall 210 is provided outside the heater 206. The outer wall 210 in cludes a side wall 210a that covers a periphery of the heater 206, a ceiling 210b that cove rs an upper portion of the heater 206, and a bottom 210c that covers a lower portion of t he heater 206.

An exhaust pipe 254, serving as an exhaust flow path for exhausting a cooling gas (cooling airflow) flowing between the reaction tube 203 and the outer wall 210, is provid ed in the outer wall 210 so as to penetrate the ceiling 210b. A blower 270, serving as a c ooling gas exhaust device, is connected to the exhaust pipe 254. An exhaust side dampe r or an exhaust side shutter for regulating an exhaust flow rate may be provided on an u pstream side of the blower 270 of the exhaust pipe 254.

Further, the outer wall 210 is provided with a supply pipe 251 for supplying a cool ing gas between the reaction tube 203 and the outer wall 210. A supply side damper 264 is connected to the supply pipe 251 as a cooling gas flow rate regulator for regulating the supply flow rate of the cooling gas. Instead of the supply side damper 264, or together w ith the supply side damper 264, a supply side shutter may be connected to the supply pi pe 251. The supply side damper 264 is capable of performing supply of the cooling gas a nd stopping the supply between the reaction tube 203 and the outer wall 210 by opening and closing a valve while the blower 270 is in operation. Furthermore, the supply side d amper 264 is configured to be capable of adjusting an opening state of the valve while th e blower 270 is operation, so that the flow rate of the cooling gas supplied between the r eaction tube 203 and the outer wall 210 is regulated. The flow rate of the cooling gas ma y also be regulated by regulating a rotation speed of the blower 270.

A cooling gas exhauster is mainly composed of the exhaust pipe 254 and the blow er 270. A cooling gas supplier is mainly composed of the supply pipe 251 and the supply side damper 264. A process chamber cooler (process chamber cooling system) as a cooli ng device is mainly composed of the cooling gas exhauster and the cooling gas supplier. The cooling gas flow rate regulator may include a blower 270 whose rotation speed is co ntrollable, in addition to the supply side damper 264. The cooling airflow (cooling gas) t aken in from the supply pipe 251 may be, for example, an air or an inert gas (e.g., a nitro gen gas or a rare gas) supplied from an inert gas supply source (not shown).

Inside the heater 206, a reaction tube 203 is disposed concentrically with the hea ter 206. The reaction tube 203 is made of a heat-resistant material such as quartz (SiO₂ ), silicon carbide (SiC) or the like and is formed in a cylindrical shape with a closed uppe r end and an opened lower end. A manifold 209 is disposed below the reaction tube 203 to be concentric with the reaction tube 203. The manifold 209 is made of a metal materi al such as stainless steel (SUS) or the like and is formed in a cylindrical shape with open ed upper and lower ends. The upper end of the manifold 209 engages with the bottom 2 10c of the outer wall 210 and is configured to support the bottom 210c. The reaction tub e 203 is installed vertically just like the heater 206. A process container (reaction contai ner) is mainly composed of the reaction tube 203 and the manifold 209. A process cha mber 201 is formed in a cylindrical hollow region of the process container. The process chamber 201 is configured to be capable of accommodating wafers the 200. The wafers 200 are processed in the process chamber 201.

A nozzle 249 as a gas introducer is provided in the process chamber 201 so as to p enetrate a side wall of the manifold 209. A gas supply pipe (not shown) is connected to t he nozzle 249. A processing gas supply source (not shown) or the like is connected to an upstream side of the gas supply pipe, which is a side opposite to a side connected to the nozzle 249, via an MFC (mass flow controller) (not shown), serving as a gas flow rate co ntroller. In addition, an opening/closing valve (e.g., air valve) (not shown) is provided o n at least one selected from the group of an upstream side and a downstream side of the MFC.

The manifold 209 is provided with an exhaust pipe 231 for exhausting an atmosp here in the process chamber 201. A vacuum pump 246 as a vacuum exhauster is connec ted to the exhaust pipe 231 via a pressure sensor (not shown) serving as a pressure detec tor for detecting a pressure in the process chamber 201 and an APC valve 244 serving as a pressure regulator. The APC valve 244 is configured to perform vacuum-exhaust of th e process chamber 201 and stop the vacuum-exhaust by opening and closing the valve w hile the vacuum pump 246 is in operation. Further, the APC valve 244 is configured to r egulate the pressure in the process chamber 201 by adjusting a valve opening state base d on pressure information detected by the pressure sensor while the vacuum pump 246 i s in operation. An exhaust system is mainly composed of the exhaust pipe 231, the APC valve 244, and the pressure sensor. The vacuum pump 246 may be included in the exha ust system.

A seal cap 219 is provided below the manifold 209 as a furnace port cover capable of airtightly closing a lower end opening of the manifold 209. The seal cap 219 is made of a metal material such as stainless steel or the like and is formed in a disk shape. The s eal cap 219 is configured to be raised and lowered vertically by a boat elevator 115, which is installed outside the reaction tube 203 and serves as a lift for a boat 217 described late r. The boat elevator 115 is configured as a transporter (transport mechanism) that raises and lowers the seal cap 219 to load and unload (transport) the wafers 200 into and out o f the process chamber 201.

A region in the process container corresponding to the heater 206a (closed end si de of the reaction tube 203) may be referred to as an upper region. A region in the proce ss container corresponding to the heater 206b may be included in the upper region. A r egion in the process container corresponding to the heater 206e may be referred to as a l ower region. A region below the heater 206e in the process container, for example, a reg ion where the manifold 209 and an opening of the reaction tube 203 are located, may be included in the lower region. A region in the process container corresponding to the hea ter 206d may be included in the lower region. Further, a region in the process container corresponding to the heater 206c may be referred to as a central region. A region in the process container corresponding to at least one selected from the group of the heaters 2 06b and 206d may be included in the central region.

The boat 217 as a substrate transporter is configured to support a plurality of waf ers 200, for example, 25 to 200 wafers, in such a state that the wafers are arranged in a horizontal posture and in multiple stages along a vertical direction with centers of the w afers 200 aligned with one another. That is, the boat 217 is configured to arrange the wa fers 200 to be spaced apart from one another. The boat 217 is made of a heat-resistant material such as, for example, quartz, SiC or the like. Heat insulating plates 218 made o f a heat-resistant material such as, for example, quartz, SiC or the like are supported in multiple stages at a lower portion of the boat 217. In the present disclosure, the expressi on of a numerical range such as "25 to 200" means that the lower limit and the upper li mit are included in the range. Therefore, for example, "25 to 200" means "25 or more a nd 200 or less." The same applies to other numerical ranges.

Inside the reaction tube 203, there is installed a temperature sensor 263 as a tem perature detector. By independently regulating a state of electric power supply to each o f the heaters 206a to 206e included in the heater 206 based on temperature information detected by the temperature sensor 263, a temperature in the process chamber 201 beco mes a desired temperature distribution. The temperature sensor 263 is installed along a n inner wall of the reaction tube 203.

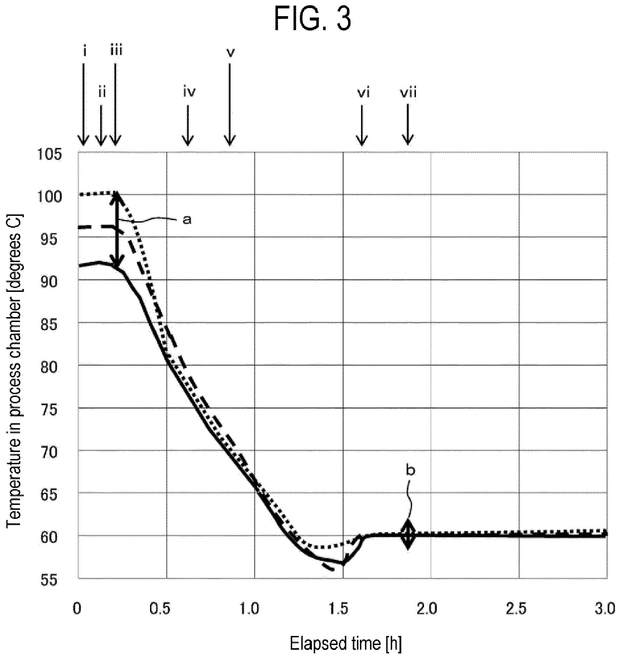

As shown in FIG. 3, the controller 121 as a control part (control means) is configu red as a computer including a CPU (Central Processing Unit) 121a, a RAM (Random Acc ess Memory) 121b, a memory 121c and an I/O port 121d. The RAM 121b, the memory 12 1c and the I/O port 121d are configured to be capable of exchanging data with the CPU 1 21a via an internal bus 121e. An input/output device 122 configured as, for example, a to uch panel or the like is connected to the controller 121. In addition, an external memory 123 may be connected to the controller 121. The substrate processing apparatus may be configured to include one controller or a plurality of controllers. That is, control for perf orming a processing sequence to be described later may be performed using one controll er or a plurality of controllers. Further, the plurality of controllers may be configured as a control system by being connected to each other via a wired or wireless communicatio n network, and the control for performing the processing sequence to be described later may be performed by the entire control system. When the term "controller" is used here in, it may include one controller, a plurality of controllers, or a control system configure d by a plurality of controllers.

The memory 121c is composed of, for example, a flash memory, a HDD (Hard Dis k Drive), a SSD (Solid State Drive), or the like. The memory 121c stores, in a readable m anner, control programs for controlling operations of the substrate processing apparatu s, process recipes in which procedures and conditions, etc. of substrate processing to be described later are written, and the like. The process recipes are combinations that caus e the controller 121 to have the substrate processing apparatus execute the respective pr ocedures in the below-described substrate processing so as to obtain a predetermined re sult. The process recipes function as programs. Hereinafter, the process recipes, the co ntrol programs and the like are collectively and simply referred to as "programs." Furth ermore, the process recipes may also be simply referred to as "recipes." When the term "programs" is used herein, it may mean a case of including the recipes, a case of includin g the control programs, or a case of including both. The RAM 121b is configured as a me mory area (work area) in which programs, data, and the like read by the CPU 121a are te mporarily held.

The I/O port 121d is connected to the MFCs, the valves, the pressure sensor, the APC valve 244, the vacuum pump 246, the heater 206, the temperature sensor 263, the supply side damper 264, the blower 270, the boat elevator 115, and the like.

The CPU 121a is configured to read a control program from the memory 121c and execute the control program, and is configured to read a recipe from the memory 121c in response to an input of an operation command and the like from the input/output devic e 122. The CPU 121a is configured to, according to the contents of the recipe thus read, c ontrol the flow rate regulating operation for various substances (various gases) by the M FCs, the opening/closing operations of the valves, the opening/closing operation of the APC valve 244, the pressure regulating operation by the APC valve 244 based on the pre ssure sensor, the start and stop of the vacuum pump 246, the temperature regulating op eration of the heater 206 based on the temperature sensor 263, the opening/closing con trol for the supply side damper 264, the start, stop and the rotation speed regulation of t he blower 270, the raising and lowering operation of the boat 217 by the boat elevator 11 5, and the like.

The controller 121 may be configured by installing, in the computer, the above-de scribed programs recorded and stored in the external memory 123. The external memor y 123 includes, for example, a magnetic disk such as a HDD or the like, an optical disk su ch as a CD or the like, a magneto-optical disk such as a MO or the like, a semiconductor memory such as a USB memory, a SSD, or the like, and so forth. The memory 121c and t he external memory 123 are configured as a computer-readable recording media. Herei nafter, the memory 121c and the external memory 123 are collectively and simply referre d to as "recording medium." When the term "recording medium" is used herein, it may refer to a case of including the memory 121c, a case of including the external memory 12 3, or case of including both. The provision of the program to the computer may be perfo rmed by using a communication means such as the Internet or a dedicated line without having to use the external memory 123.

### (2) Substrate Processing Process

An example of substrate processing performed as a process of manufacturing a se miconductor device using the above-described substrate processing apparatus is describ ed mainly with reference to FIG. 3. In the following description, the operation of each p art included in the substrate processing apparatus is controlled by the controller 121.

The substrate processing according to the present embodiments includes:
(a) step A of regulating a temperature in a process chamber 201 configured to ac commodate a plurality of wafers 200 so that a temperature distribution in an arrangeme nt direction of the wafers 200 in the process chamber 201 becomes a first distribution in which at least a portion of an inside of the process chamber 201 becomes a first tempera ture;
(b) step B of loading the wafers 200 into the process chamber 201 in a state in w hich the temperature distribution in the arrangement direction of the wafers 200 in the process chamber 201 is the first distribution;
(c) step C of, after step B, regulating the temperature in the process chamber 201 so that the temperature distribution in the arrangement direction of the wafers 200 in t he process chamber 201 becomes a second distribution in which at least a portion of the inside of the process chamber 201 becomes a second temperature different from the firs t temperature; and
(d) step D of, after step C, processing the wafers 200 in a state in which the temp erature distribution in the arrangement direction of the wafers 200 in the process cham ber 201 is the second distribution.

### (Step A: First Temperature Regulating Step)

In step A, the temperature in the process chamber 201 is regulated to a predeter mined temperature.

A detailed description is given below with reference to FIG. 3. FIG. 3 shows the t emperature in the process chamber 201 at a predetermined timing for each of the upper region, the central region, and the lower region. The vertical axis in FIG. 3 indicates the temperature in each region in the process chamber 201 in [degrees C]. The horizontal a xis in FIG. 3 indicates an elapsed time in [h]. The dotted line in FIG. 3 indicates the tem perature at the lower region in the process chamber 201. The dashed line indicates the t emperature at the central region in the process chamber 201. The solid line indicates th e temperature at the upper region in the process chamber 201. The arrow i in the upper part of FIG. 3 indicates a time when the temperature in the process chamber 201 exhibit s a predetermined distribution (first distribution) due to the temperature regulating in s tep A, and indicates a time when the substrate processing apparatus is in an idle state to be described later. The arrow ii indicates a time when the substrate processing apparatu s is in a standby state to be described later. The arrow iii indicates a start time of step B to be described later. The arrow iv indicates a start time of a pressure regulating step to be described later. The arrows v and vi indicate a start time and an end time of a proces s chamber cooling process of step C to be described later. The arrow vii indicates a start time of step D to be described later.

In step A, while the substrate processing apparatus is in a waiting state (idle state ) until its transitions to the standby state, the temperature in the process chamber 201 is regulated so that the temperature distribution in the arrangement direction of the wafer s 200 in the process chamber 201 becomes the first distribution (see a in FIG. 3) in whic h at least a portion (e.g., the lower region) in the process chamber 201 becomes the first temperature (e.g., 100 degrees C). More specifically, set temperatures of the heaters 20 6a to 206e are regulated to achieves the first distribution in which the temperatures in t he upper region, the central region, and the lower region are, for example, 92 degrees C, 96 degrees C, and 100 degrees C (see arrow i in FIG. 3). At this time, the state of power supply to the heater 206 is feedback-controlled based on the temperature information d etected by the temperature sensor 263 so that the process chamber 201 achieves such a t emperature distribution. By doing so, 100 degrees C, which is the temperature in the lo wer region, becomes a maximum temperature value (first temperature) in the first distri bution, and 92 degrees C, which is the temperature in the upper region, becomes a mini mum temperature value in the first distribution. In the present embodiments, for exam ple, the first distribution possesses a first deviation, i.e., a temperature width of 100 deg rees C - 92 degrees C = 8 degrees C. As the temperature in each region in the process c hamber 201 regulated in this step and step C, the temperature detected by the temperat ure sensor 263 provided in each region may be used.

It is not necessary to keep all of the heaters 206a to 206e in an on state for an ent ire period of this step. During at least a portion of the period, at least one selected from the group of the heaters 206a to 206e maybe turned off while the other heaters are turn ed on to regulate the temperature in the process chamber 201.

### (Step B: Wafer Loading Step)

Thereafter, when the substrate processing apparatus receives an instruction to ex ecute step B and transitions to the standby state (see arrow ii in FIG. 3), the lower end o pening of the manifold 209 is opened, and as shown in FIG. 1, the boat 217 supporting t he plurality of wafers 200 is raised by the boat elevator 115 and loaded into the process c hamber 201 (boat loading). In this state, the seal cap 219 seals the lower end of the man ifold 209. In this way, the wafers 200 are loaded (provided) into the process chamber 2 01.

At this time, in the present embodiments, the wafers 200 are loaded into the proc ess chamber 201 in a state in which the temperature distribution in the arrangement dir ection of the wafers 200 in the process chamber 201 is in the above-mentioned first dist ribution (see arrow iii in FIG. 3). In this step, the boat 217, which is disposed outside th e substrate processing apparatus and possesses a lower temperature than the temperatu re in the process chamber 201 at a time of loading, is loaded into the substrate processin g apparatus. Therefore, the temperature in the process chamber 201 drops to about 80 degrees C (*see* FIG. 3).

### (Step C: Second Temperature Regulating Step)

When the substrate processing apparatus transitions to the standby state, temper ature regulating in the process chamber 201 is started as a second temperature regulatin g step. Specifically, the set temperatures of the heaters 206a to 206e are regulated so th at the temperature distribution in the arrangement direction of the wafers 200 in the pr ocess chamber 201 becomes the second distribution (target temperature distribution) (s ee b in FIG. 3) in which at least a portion (e.g., the lower region) in the process chamber 201 becomes a second temperature (e.g., 60 degrees C), which is a target temperature. F or example, the set temperatures of the heaters 206a to 206e are regulated so that the te mperatures in the upper region, the central region, and the lower region become 60 degr ees C. That is, in the present embodiments, maximum and minimum values of the temp erature in the second distribution are 60 degrees C, and a second deviation (temperatur e width) of the second distribution is 0 degrees C. However, even when the set temperat ure of the heater 206 is regulated (changed) in this manner, the temperature in the proc ess chamber 201 does not immediately drop, and the temperature during the standby st ate (approximately 100 degrees C) is essentially maintained for at least a predetermined time until step B is started (*see* FIG. 3).

The temperature regulating by the heater 206 as the second temperature regulati ng step is continuously performed even after the start of step B until an end of step D, in accordance with the set temperature of the heater 206 that is regulated to allow the tem perature distribution in the process chamber 201 to achieve the second distribution. A s tart timing of the second temperature regulating step is not limited to before the start of step B (the time of transition to the standby state), and may be simultaneous with the st art of step B or any timing between an end of step B and a start of step D.

In the present embodiments, the second temperature regulating step further incl udes cooling the process chamber 201 by the process chamber cooler so as to bring the t emperature distribution in the process chamber 201 closer to the second distribution (pr ocess chamber cooling step). Specifically, the cooling gas discharged by the blower 270 i s circulated through a space between the reaction tube 203 and the outer wall 210 (an o uter space of the process chamber 201) via the supply pipe 251 to lower the temperature in the process chamber 201. At this time, the flow rate of the cooling gas discharged by t he blower 270 is regulated so as to bring the temperature in the process chamber 201 clo ser to the second distribution (see arrows v and vi in FIG. 3). The flow rate of the coolin g gas is regulated by at least one selected from the group of regulating the opening state of the supply side damper 264 and regulating the rotation speed of the blower 270. The cooling gas supplied to between the reaction tube 203 and the outer wall 210 is exhauste d via the exhaust pipe 254.

In the present embodiments, by using both temperature control using the heater 206 and temperature control using the blower 270 (cooling device) as the second tempe rature regulating step from the time of the arrow v to the time of the arrow vi, it is possi ble to shorten a time taken until the temperature converges to the second distribution w hen the first temperature is higher than the second temperature. In addition, since accu racy of the temperature control by the heater 206 may increase even in a low temperatur e region, it is possible to shorten the time taken until the temperature converges to the s econd distribution. This is because, in the low temperature region, it may be difficult to perform accurate temperature control by solely controlling the power of the heater 206. As in the present embodiments, by controlling the power of the heater 206 while cooling the heater 206, it is possible to control the temperature with a high precision via the con trol of the power of the heater 206 even in the low temperature region.

### (Pressure Regulating Step)

After step B is completed, the vacuum pump 246 performs vacuum-exhaust (deco mpression-exhaust) so that the pressure inside the process chamber 201, i.e., a space in which the wafer 200 exists, reaches a desired pressure (vacuum level) (*see* arrow iv in FI G. 3). At this time, the pressure inside the process chamber 201 is measured by the pres sure sensor, and the APC valve 244 is feedback-controlled based on the measured press ure information. The exhaust of the inside of the process chamber 201 continues at leas t until the processing of the wafers 200 is started.

### (Step D: Substrate Processing Step)

After the temperature in the process chamber 201 is regulated to the second distr ibution in step C, the wafers 200 loaded into the process chamber 201 are processed. As an example, predetermined precursor gas, reaction gas, and inert gas are supplied to the wafers 200 in the process chamber 201 to form a desired film on the wafers 200.

That is, in the present embodiments, the wafers 200 are processed in a state in w hich the temperature distribution in the arrangement direction of the wafers 200 in the process chamber 201 is set to the second distribution.

### (After-Purge and Atmospheric Pressure Recovery)

After step D is completed, an inert gas as a purge gas is supplied into the process chamber 201 from the nozzle and is exhausted through the exhaust pipe 231. As a result , the inside of the process chamber 201 is purged, and gases, reaction by-products, and t he like remaining in the process chamber 201 are removed from the inside of the proces s chamber 201 (after-purge). Thereafter, the atmosphere in the process chamber 201 is replaced with the inert gas (inert gas replacement), and the pressure in the process cha mber 201 is returned to normal pressure (atmospheric pressure recovery).

### (Boat Unloading and Wafer Discharge)

Thereafter, the seal cap 219 is lowered by the boat elevator 115, and the lower end of the manifold 209 is opened. Then, the processed wafers 200 are unloaded from the l ower end of the manifold 209 to the outside of the reaction tube 203 while being suppor ted by the boat 217 (boat unloading). After the boat is unloaded, the lower end opening of the manifold 209 is sealed (shutter close). The processed wafers 200 are discharged f rom the boat 217 after they are unloaded to the outside of the reaction tube 203 (wafer d ischarge).

### (Step A': First Temperature Regulating Step)

After the boat unloading and the shutter close, the substrate processing apparatu s transitions to an idle state again, and the heater 206 is controlled to regulate the temp erature distribution in the process chamber 201 to become the first distribution.

### (3) Effects of the Present Embodiments

According to the present embodiments, one or more of the following effects may be obtained.

(a) In step A, the temperature distribution in the process chamber 201 is regulate d to the first temperature distribution different from the second distribution (target tem perature distribution) used during performing step D, and in step B, the wafers 200 are loaded into the process chamber 201 in the state in which the temperature distribution i s set to the first distribution. Furthermore, in step C, the temperature is regulated to the second temperature distribution, and in step D, the wafers 200 are processed in the stat e in which the temperature distribution is set to the second distribution. As a result, wh en the temperature distribution in the process chamber 201, which fluctuates due to the loading of the wafers 200 into the process chamber 201, is converged to the second distr ibution, which is the target temperature distribution, the time required for the converge nce may be shortened, thus improving a throughput of the substrate processing. This is described below.

When step B is performed, the boat 217 of a low temperature waiting outside the process chamber 201 is loaded into the process chamber 201, so that the temperature in the process chamber 201 drops. At this time, the boat 217 is raised from an open end sid e of the reaction tube 203 to the closed end side, so that an upper portion of the boat 217 heated by the entire heaters, for example, in the order of the heaters 206e, 206d, 206c, a nd 206b, is disposed in the upper region. A central portion of the boat 217 heated by the three heaters, for example, in the order of the heaters 206e and 206d, is disposed in the central region. The lower portion of the boat 217 heated solely by the heater 206e or har dly heated by the heater 206 is disposed in the lower region. In this way, the portions of the boat 217 that are heated by the heater 206 for different times during the boat loadin g depending on the regions are disposed in the process chamber 201. As a result, the te mperature in the process chamber 201 after the boat 217 is loaded tends to exhibit devia tions (variations) depending on the regions. Specifically, the temperature is highest in t he upper region, and the temperature decreases downward from the central region to th e lower region. Furthermore, since the boat loading in step B is performed in the state i n which the lower end opening of the manifold 209 is opened, a low-temperature air out side the substrate processing apparatus flows into the substrate processing apparatus, t hereby lowering the temperature in the process chamber 201. The lower region close to the lower end opening of the manifold 209 is most susceptible to the influence of this te mperature drop, and the influence becomes less noticeable upward from the central regi on to the upper region. In the lower region, the temperature drop begins immediately af ter the start of boat loading, and then the temperature drop begins in the order of the ce ntral region and the upper region. In other words, a manner of temperature change ove r time after the start of boat loading (i.e., characteristics of the temperature change) diff ers from region to region. Furthermore, the temperature drop is greatest in the lower re gion, and the temperature drop decreases upward from the central region to the upper r egion. This enhances the tendency that the temperature in the process chamber 201 var ies from region to region when step B is performed. If a large variation in the temperatu re distribution in the process chamber 201 occurs when step B is performed, a time requ ired to eliminate this variation, i.e., a time required for the temperature distribution in t he process chamber 201 to converge to the second distribution (target temperature distr ibution) (convergence time), may become long. This causes a delay in the start of step D , which may reduce the throughput.

In the present embodiments, in consideration of the temperature variation in the process chamber 201 that occurs during the execution of step B, the temperature distrib ution in the process chamber 201 is regulated in step A to the first distribution different from the second distribution that is the target temperature distribution. This makes it p ossible to shorten a time required for the temperature distribution in step C to converge to the second distribution. As a result, the start of step D may be advanced, and a decre ase in the throughput may be avoided.

(b) By making the first temperature of the first distribution in step A higher than the second temperature of the second distribution in step C, it is possible to facilitate the temperature regulating (temperature control) using the heater 206 and shorten the time required to converge to the second distribution (target temperature distribution). Furth ermore, by maintaining the inside of the process chamber 201 at a high temperature bef ore performing step B in which the wafers 200 are loaded, it is possible to remove moist ure in the process chamber 201 and reduce the influence of moisture in the process cha mber 201 when performing step D.

(c) By making the minimum temperature value in the first distribution higher tha n the maximum temperature value in the second distribution, it is possible to improve t he controllability of the temperature regulating using the heater 206 in step A. This ma kes it easier to further shorten the time required for the temperature distribution in the process chamber 201 to converge to the second distribution.

(d) In step A, the heater 206 is controlled so that the first distribution exhibits th e first deviation. In this manner, by giving, in advance, a predetermined deviation (tem perature width) to the first distribution in step A, it is possible to reduce the temperatur e deviation (temperature variation from region to region) in the arrangement direction o f the wafers 200 that occurs when the wafers 200 are loaded into the process chamber 2 01.

(e) In step C, the temperature in the process chamber 201 is regulated so that the second distribution becomes uniform (the second deviation is zero) in the arrangement direction of the wafers 200. In this manner, by reducing the temperature deviation (te mperature variation) in the process chamber 201 that occurs when the wafers 200 are lo aded into the process chamber 201, it is possible to shorten the convergence time when performing the temperature control to obtain the second distribution in which the secon d deviation is zero.

(f) The first distribution is set such that the time taken for the temperature distrib ution in the process chamber 201 to converge to the second distribution from the start o f step B is shorter compared to a case where the temperature in the process chamber 201 is regulated so that the temperature distribution in the process chamber 201 becomes th e second distribution in step A. This makes it possible to shorten the convergence time and therefore improve the throughput.

(g) The first distribution is set such that a maximum value of the deviation of the temperature distribution in the process chamber 201 occurring after step B is smaller th an that in the case where the temperature in the process chamber 201 is regulated to all ow the temperature distribution in the process chamber 201 to become the second distri bution in step A. This makes it possible to shorten the convergence time, thereby impro ving the throughput.

(h) The first distribution is set according to the characteristics of the change in th e temperature distribution in the process chamber 201 caused by the loading of the wafe rs 200 in step B. Specifically, as described above, the lower region (the opening side of t he reaction tube 203) is most susceptible to the influence of the temperature drop in the process chamber 201 caused by the loading of the wafers 200, and the influence is less n oticeable upward, i.e., toward the central region and the upper region (the closed end si de of the reaction tube 203). Taking this characteristic into consideration, in the presen t embodiments, the first distribution is set to possess a deviation that cancels (compensa tes for) the temperature variation that occurs when the wafers 200 are loaded. In detail, the temperature of the lower region is set to the maximum value in the first distribution, and the temperature of the upper region is set to the minimum value in the first distribu tion (*see* FIG. 3). By doing so, the convergence time may be further shortened, thereby f urther improving the throughput.

(i) The temperature of the process chamber 201 is regulated by controlling the he ater 206 that heats the process chamber 201 in step A and controlling the heater 206 an d the blower 270 that cools the process chamber 201 in step C, thus ensuring the above-mentioned effects.

### (4) Modifications

The substrate processing in the present embodiments may be modified as shown in the following modifications. These modifications may be combined as desired. Unles s otherwise specified, the processing procedure and processing condition in each step of each modification may be the same as the processing procedure and processing conditio n in each step of the substrate processing described above.

### (Modification 1)

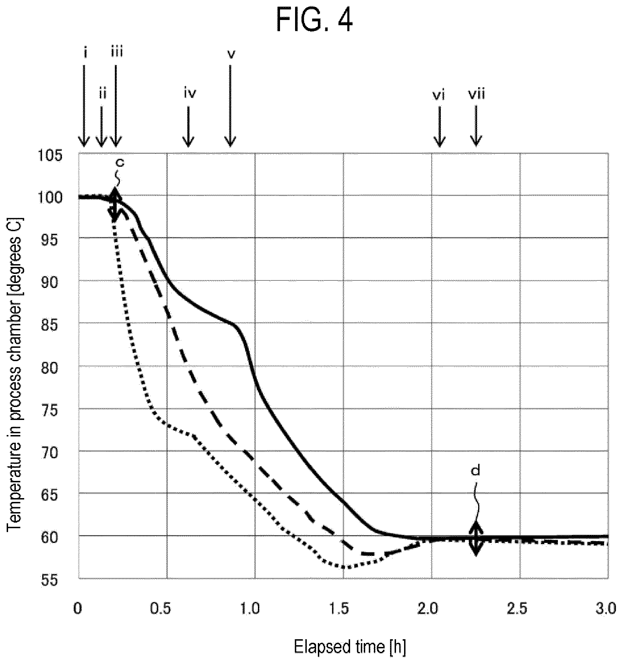

As shown in FIG. 4, in step A, it is not necessary to give a deviation (first deviatio n) to the first distribution (*see* c in Fig. 4) in advance to cancel the temperature deviatio n (temperature variation) that occurs when the wafers 200 are loaded. In other words, when the substrate processing apparatus is in the idle state, the temperature distributio n in the process chamber 201 may be a first distribution in which the upper region, the c entral region, and the lower region are at the first temperature (e.g., about 100 degrees C) (*see* arrow i in FIG. 4). In other words, when the substrate processing apparatus is in the idle state, the entire regions in the process chamber 201 may be heated uniformly so that they are at approximately the same temperature (*see* FIG. 4).

FIG. 4 shows the temperature in the process chamber 201 at a predetermined tim ing for each of the upper region, the central region, and the lower region. The vertical ax is in FIG. 4 indicates the temperature in each region of the process chamber 201 in [degr ees C]. The horizontal axis in FIG. 4 indicates the elapsed time in [h]. The dotted line in FIG. 4 indicates the temperature at the lower region in the process chamber 201. The da shed line indicates the temperature at the central region in the process chamber 201. Th e solid line indicates the temperature at the upper region in the process chamber 201. T he arrow i in the upper part of FIG. 4 indicates the time when the temperature in the pro cess chamber 201 exhibits a predetermined distribution (first distribution) due to the te mperature regulating in step A, and indicates the time when the substrate processing ap paratus is in the idle state. The arrow ii indicates the time when the substrate processin g apparatus is in the standby state. The arrow iii indicates the start time of step B. The arrow iv indicates the start time of the pressure regulating step. The arrows v and vi ind icate the start time and end time of the process chamber cooling process of step C. The arrow vii indicates the start time of step D.

In this modification as well, by loading the wafers 200 at a temperature higher th an a temperature range in the substrate processing step (*see* arrows iii and vii in FIG. 4), the temperature controllability is better than when loading the wafers 200 at the temper ature range in the substrate processing process, and therefore the effect of shortening th e convergence time is obtained.

### (Modification 2)

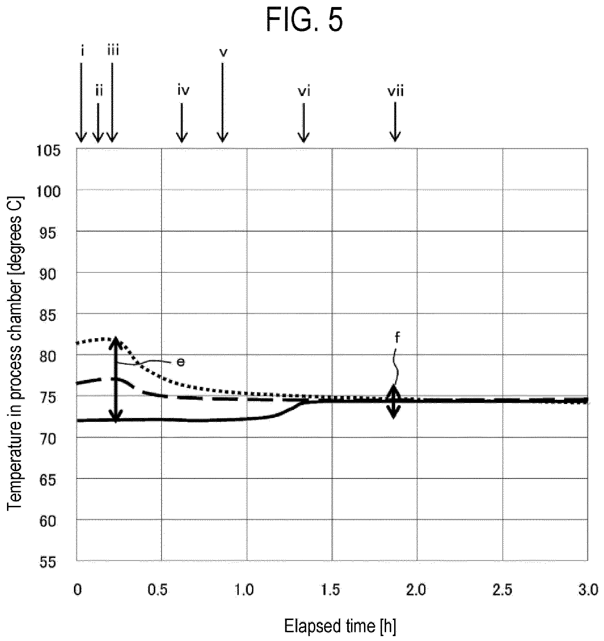

As shown in FIG. 5, in step A, the temperature in the process chamber 201 may b e regulated to a first distribution (*see* e in FIG. 5) that is at a same temperature range (a bout 75 degrees C) as the target temperature distribution (second distribution) (*see* f in FIG. 5). In other words, when the substrate processing apparatus is in the idle state, the temperature distribution in the process chamber 201 may be a first distribution in whic h the upper region, the central region, and the lower region are at relatively low tempera tures similar to the temperature range (about 75 degrees C) in the substrate processing s tep (*see* arrows i and vii in FIG. 5). In this way, when the substrate processing apparatu s is in the idle state, the temperature distribution in the process chamber 201 may be a fi rst distribution that is lower than that in the above-described embodiments. For exampl e, the minimum value of the temperature in the first distribution may be lower than the maximum value of the temperature in the second distribution (*see* FIG. 5).

FIG. 5 shows the temperature in the process chamber 201 at a predetermined tim ing for each of the upper region, the central region, and the lower region. The vertical ax is in FIG. 5 indicates the temperature in each region of the process chamber 201 in [degr ees C]. The horizontal axis in FIG. 5 indicates the elapsed time in [h]. The dotted line in FIG. 5 indicates the temperature at the lower region in the process chamber 201. The da shed line indicates the temperature at the central region in the process chamber 201. Th e solid line indicates the temperature at the upper region in the process chamber 201. T he arrow i in the upper part of FIG. 5 indicates the time when the temperature in the pro cess chamber 201 exhibits a predetermined distribution (first distribution) due to the te mperature regulating in step A, and indicates the time when the substrate processing ap paratus is in the idle state. The arrow ii indicates the time when the substrate processin g apparatus is in the standby state. The arrow iii indicates the start time of step B. The arrow iv indicates the start time of the pressure regulating step. The arrows v and vi ind icate the start time and end time of the process chamber cooling process of step C. The arrow vii indicates the start time of step D.

In this modification as well, a deviation that cancels out the temperature deviatio n (temperature variation) that occurs when the wafers 200 are loaded is given to the firs t distribution in advance in step A, and then the wafers 200 are loaded (*see* arrow i in FI G. 5), thereby achieving the effect of shortening the convergence time as compared to a c ase where the wafers 200 are loaded without giving this deviation to the first distributio n.

### <Other Embodiments of the Present Disclosure>

The embodiments of the present disclosure are specifically described above. How ever, the present disclosure is not limited to the above-described embodiments, and vari ous changes may be made without departing from the spirit of the present disclosure.

For example, in the above-described embodiments, the case where the temperatu re in the process chamber 201 is regulated using the heater 206 in step A is described as an example. However, the present disclosure is not limited to such embodiments. For e xample, the temperature in the process chamber 201 may be regulated by simultaneousl y using the heater 206 and the blower 270 during at least a portion of the period of step A. The same effects as those of the above-described embodiments may be obtained in th is embodiment. Furthermore, in this embodiment, a sufficient temperature deviation (ti lt controllable width) may be provided in advance even in a low temperature region. Thi s is because temperature control in a temperature decreasing direction is not possible to be performed solely by power control of the heater 206. Therefore, especially in the low temperature region, it may be difficult to perform temperature control that locally create s a temperature difference. By simultaneously using the blower 270 as in this embodim ent, the power control of the heater 206 is performed while cooling the reaction tube 20 3 (process chamber 201) and the heater 206. Therefore, the temperature control to loca lly create a temperature difference by the power control of the heater 206 may be easily performed even in the low temperature region, and a sufficient temperature deviation m ay be provided.

For example, in the above-described embodiments, the case where the heater 206 and the blower 270 are used simultaneously to regulate the temperature in the process c hamber 201 during at least a portion of the period of step C is described as an example. However, the present disclosure is not limited to such embodiments. For example, the t emperature in the process chamber 201 may be regulated using solely the blower 270 du ring at least a portion of the period of step C. That is, the power supply to the heater 20 6 may be stopped (turned off) during at least a portion of the period of step C. In this ca se, for example, the temperature control using the heater 206 may be started or resume d at a timing when a temperature of any region in the process chamber 201 drops to a pr edetermined temperature or lower. In this embodiment, the same effects as those of the above-described embodiments may be obtained.

For example, in the above-described embodiments, in step C, the case where the t emperature in the process chamber 201 is regulated so that the second distribution is un iform (the second deviation is zero) in the arrangement direction of the wafers 200 is de scribed as an example. However, the present disclosure is not limited to such embodim ents. For example, the second distribution may possess a second deviation that is small er than the first deviation other than zero. In this embodiment, the same effects as thos e of the above-described embodiments may be obtained.

Although not specifically described in the above-described embodiments, when t he first temperature is set (controlled) to be higher than the second temperature, step E of increasing the temperature in the process chamber 201 after step D in a state in which the plurality of wafers 200 are accommodated in the process chamber 201, and step F of unloading the wafers 200 from the process chamber 201 after step E may be further perf ormed. In this embodiment, the same effects as those of the above-described embodime nts may be obtained. Furthermore, in this embodiment, the wafers 200 may be unloade d from the process chamber 201 after removing moisture generated during the processi ng of step D from the wafers 200 and the process chamber 201. In addition, a time requ ired for increasing the temperature in the process chamber 201 after unloading the wafe rs 200 may be shortened.

For example, in the above-described embodiments, the case where cooling by the blower 270 is started after the inside of the process chamber 201 is vacuum-exhausted is described as an example. However, the present disclosure is not limited to such embodi ments. For example, cooling by the blower 270 may be started before the vacuum-exha ust of the inside of the process chamber 201 is completed. In this embodiment, the sam e effects as those of the above-described embodiments may be obtained.

For example, in the above-described embodiments, the case where the temperatu re in the process chamber 201 is lowered by allowing the cooling gas taken in through th e supply pipe 251 to circulate in an outer peripheral space of the process chamber 201 an d then be discharged by the blower 270 is described as an example. However, the prese nt disclosure is not limited to such embodiments. For example, the flow direction of the cooling gas may be reversed from that of the above-described embodiments. That is, the temperature in the process chamber 201 may be lowered by allowing the cooling gas tak en in through the exhaust pipe 254 to circulate in the outer peripheral space of the proce ss chamber 201 and then be discharged by a blower provided on the side of the supply pi pe 251. In this embodiment, the same effects as those of the above-described embodime nts may be obtained.

It is preferable that a recipe used for each process is prepared separately accordin g to processing contents and are recorded and stored in the memory 121c via an electric communication line or an external memory 123. When starting each process, it is prefer able that the CPU 121a suitably selects an appropriate recipe from a plurality of recipes r ecorded and stored in the memory 121c according to the processing contents. This make s it possible to form films of various film types, composition ratios, film qualities and fil m thicknesses with high reproducibility in one substrate processing apparatus. In additi on, the burden on an operator may be reduced, enabling a quick start of each process wh ile avoiding operation errors.

The above-described recipes are not limited to newly prepared ones, but may be p repared by, for example, changing existing recipes already installed in the substrate proc essing apparatus. In the case of changing the recipes, the recipes after the change may b e installed in the substrate processing apparatus via an electric communication line or a recording medium in which the recipes are recorded. In addition, the input/output devi ce 122 provided in the existing substrate processing apparatus may be operated to direct ly change the existing recipes already installed in the substrate processing apparatus.

In the above-described embodiments, there is described the example in which a fi lm is formed by using a batch type substrate processing apparatus that processes a plura lity of substrates at a time. The present disclosure is not limited to the above-described embodiments, but may be suitably applied to, for example, a case where a film is formed using a single-substrate type substrate processing apparatus that processes one or sever al substrates at a time. Furthermore, in the above-described embodiments, there is desc ribed the example in which a film is formed using a substrate processing apparatus with a hot-wall type process furnace. The present disclosure is not limited to the above-desc ribed embodiments, but may also be suitably applied to a case where a film is formed usi ng a substrate processing apparatus with a cold-wall type process furnace.

Even when these substrate processing apparatuses are used, each process may be performed under the same processing procedures and processing conditions as those of the above-described embodiments and modifications. The same effects as those of the a bove-described embodiments and modifications may be obtained.

The above-described embodiments and modifications may be used in combinatio n as appropriate. The processing procedure and processing conditions at this time may be, for example, the same as the processing procedures and processing conditions of the above-described embodiments and modifications.

According to the present disclosure in some embodiments, it is possible to shorte n a time required for converging a temperature distribution in a process chamber, which fluctuates when loading a substrate into the process chamber, to a target temperature di stribution, thereby improving a throughput of substrate processing.

While certain embodiments are described, these embodiments are presented by way of example, and are not intended to limit the scope of the disclosures. Indeed, the e mbodiments described herein may be embodied in a variety of other forms. Furthermor e, various omissions, substitutions, and changes in the form of the embodiments describ ed herein may be made without departing from the spirit of the disclosures. The accom panying claims and their equivalents are intended to cover such forms or modifications as would fall within the scope and spirit of the disclosures.

## Claims

1. A substrate processing method, comprising:
(a) regulating a temperature in a process chamber (201) configured to be capable of accommodating a plurality of substrates (200) so that a temperature distribution in a n arrangement direction of the plurality of substrates (200) in the process chamber (201 ) becomes a first distribution in which at least a portion of an inside of the process cham ber (201) becomes a first temperature;
(b) loading the plurality of substrates (200) into the process chamber (201) in a s tate in which the temperature distribution in the arrangement direction in the process c hamber (201) is the first distribution;
(c) after (b), regulating the temperature in the process chamber (201) so that the temperature distribution in the arrangement direction in the process chamber (201) bec omes a second distribution in which at least a portion of the inside of the process chamb er (201) becomes a second temperature different from the first temperature; and
(d) after (c), processing the plurality of substrates (200) in a state in which the te mperature distribution in the arrangement direction in the process chamber (201) is the second distribution.

2. The substrate processing method of Claim 1, wherein the first temperature is high er than the second temperature.

3. The substrate processing method of Claim 2, wherein a minimum temperature val ue in the first distribution is higher than a maximum temperature value in the second di stribution.

4. The substrate processing method of Claim 2, wherein a minimum temperature val ue in the first distribution is lower than a maximum temperature value in the second dis tribution.

5. The substrate processing method of any one of Claim 1 to 4, wherein in (a), the te mperature in the process chamber (201) is regulated so that the first distribution has a fi rst deviation in the arrangement direction.

6. The substrate processing method of Claim 5, wherein in (c), the temperature in th e process chamber (201) is regulated so that the second distribution has a second deviati on smaller than the first deviation or is uniform in the arrangement direction.

7. The substrate processing method of Claim 5 or 6, wherein the first distribution is s et such that a time taken for the temperature distribution in the arrangement direction i n the process chamber (201) to converge to the second distribution from a start of (b) is shorter compared to a case where the temperature in the process chamber (201) is regul ated so that the temperature distribution in the arrangement direction in the process ch amber (201) becomes the second distribution in (a).

8. The substrate processing method of any one of Claim 5 to 7, wherein the first distri bution is set such that a maximum value of a temperature deviation in the arrangement direction in the process chamber (201) occurring after (b) is smaller compared to a case where the temperature in the process chamber (201) is regulated so that the temperatur e distribution in the arrangement direction in the process chamber (201) becomes the se cond distribution in (a).

9. The substrate processing method of any one of Claim 5 to 8, wherein the first distr ibution is set according to a characteristic of a change in the temperature distribution in the arrangement direction in the process chamber (201), which occurs when the pluralit y of substrates (200) are loaded in (b).

10. The substrate processing method of Claim 9, wherein a characteristic of a tempera ture change in the process chamber (201) with respect to a lapse of time after starting th e loading of the plurality of substrates (200), which occurs when the plurality of substrat es (200) are loaded in (b), differs depending on a position in the arrangement direction.

11. The substrate processing method of Claim 1, wherein the first temperature is high er than the second temperature, and
wherein in (a) and (c), the temperature in the process chamber (201) is regulated so that each of the first distribution and the second distribution becomes uniform in the arrangement direction.

12. The substrate processing method of any one of Claims 1 to 11, wherein in (a) and (c ), the temperature in the process chamber (201) is regulated by controlling at least one s elected from the group of a heater (206) configured to heat the process chamber (201) a nd a cooler configured to cool the process chamber (201).

13. A method of manufacturing a semiconductor device, comprising the substrate processing method of Claim 1.

14. A program that causes, by a computer, a substrate processing apparatus to perfor m a process comprising:
(a) regulating a temperature in a process chamber (201) configured to be capable of accommodating a plurality of substrates (200) so that a temperature distribution in a n arrangement direction of the plurality of substrates (200) in the process chamber (201 ) becomes a first distribution in which at least a portion of an inside of the process cham ber (201) becomes a first temperature;
(b) loading the plurality of substrates (200) into the process chamber (201) in a s tate in which the temperature distribution in the arrangement direction in the process c hamber (201) is the first distribution;
(c) after (b), regulating the temperature in the process chamber (201) so that the temperature distribution in the arrangement direction in the process chamber (201) bec omes a second distribution in which at least a portion of the inside of the process chamb er (201) becomes a second temperature different from the first temperature; and
(d) after (c), processing the plurality of substrates (200) in a state in which the te mperature distribution in the arrangement direction in the process chamber (201) is the second distribution.

15. A substrate processing apparatus, comprising:
a process chamber (201) configured to be capable of accommodating a plurality of substrates (200);
a substrate transporter (217) configured to load the plurality of substrates (200) into the process chamber (201);
a heater (206) configured to heat an inside of the process chamber (201); and
a controller (121) configured to be capable of controlling the substrate transporter (217) and the heater (206) to perform a process including:
(a) regulating a temperature in the process chamber (201) so that a temp erature distribution in an arrangement direction of the plurality of substrates (2 00) in the process chamber (201) becomes a first distribution in which at least a portion of the inside of the process chamber (201) becomes a first temperature;
(b) loading the plurality of substrates (200) into the process chamber (20 1) in a state in which the temperature distribution in the arrangement direction i n the process chamber (201) is the first distribution;
(c) after (b), regulating the temperature in the process chamber (201) so that the temperature distribution in the arrangement direction in the process ch amber (201) becomes a second distribution in which at least a portion of the insi de of the process chamber (201) becomes a second temperature different from th e first temperature; and
(d) after (c), processing the plurality of substrates (200) in a state in whic h the temperature distribution in the arrangement direction in the process cham ber (201) is the second distribution.
